Europäisches Patentamt

European Patent Office

Office européen des brevets

(19)

(11) Numéro de publication : **0 042 773**
**B1**

## (12) FASCICULE DE BREVET EUROPÉEN

(45) Date de publication du fascicule du brevet :
20.04.83

(51) Int. Cl.³ : **H 01 L 31/18, C 23 C 11/06**

(21) Numéro de dépôt : **81400880.1**

(22) Date de dépôt : **02.06.81**

(54) **Procédé de réalisation d'une couche contenant du silicium, et son application aux dispositifs de conversion photoélectrique.**

(30) Priorité : 24.06.80 FR 8013968

(43) Date de publication de la demande :
30.12.81 Bulletin 81/52

(45) Mention de la délivrance du brevet :
20.04.83 Bulletin 83/16

(84) Etats contractants désignés :
**DE GB IT NL**

(56) Documents cités :
**WO A 79/00724**
**FR A·2 433 871**

**EXTENDED ABSTRACTS, vol. 80-1, mai 1980, résumé 361 PRINCETON (US) M.C. CRETELLA et al. : « Hydrogenated a-SixGe1-x for solar cells », page 896**

(73) Titulaire : **THOMSON-CSF**
**173, Boulevard Haussmann**
**F-75379 Paris Cedex 08 (FR)**

(72) Inventeur : **Kaplan, Daniel**
**THOMSON-CSF SCPI 173, bld Haussmann**
**F-75360 Paris Cedex (FR)** ·
Inventeur : **Landouar, Pierre**
**THOMSON-CSF SCPI 173, bld Hausmann**
**F-75360 Paris Cedex (FR)**
Inventeur : **Criton, Eric**
**THOMSON-CSF SCPI 173, bld Hausmann**
**F-75360 Paris Cedex (FR)**

(74) Mandataire : **Lepercque, Jean et al**
**THOMSON-CSF SCPI 173, Bld Haussmann**
**F-75379 Paris Cedex 08 (FR)**

EP 0 042 773 B1

# Procédé de réalisation d'une couche contenant du silicium et son application aux dispositifs de conversion photoélectrique

La présente invention concerne un procédé de fabrication de dispositifs semiconducteurs comprenant une couche de silicium. L'invention s'applique notamment à la fabrication de dispositifs de conversion photoélectrique tels que les cellules photovoltaïques.

Ces dispositifs semiconducteurs possèdent généralement une structure multicouche, comprenant au moins une jonction p-n ou un contact métal-semiconducteur. On utilise le plus souvent comme matériau semiconducteur de base le silicium. Les couches de matériau semiconducteur sont réalisées par les techniques dites de dépôt en couche mince sur un substrat assurant notamment la tenue mécanique du dispositif.

Lorsqu'on dépose, par tout procédé connu, une couche mince de silicium sur un substrat non cristallin, tel que du verre de silice, on n'obtient pas une couche monocristalline mais une couche ayant une structure polycristalline ou amorphe, selon les conditions de dépôt et notamment la température sous laquelle s'effectue ce dépôt.

Dans les couches polycristallines, il existe des joints de grains entre les divers cristaux qui ont pour effet de détériorer les qualités électriques de la couche de semiconducteur. Si la couche n'est pas fortement dopée n ou p, sa conductivité est en général très inférieure à celle du cristal correspondant. En outre la conductivité est dépendante de la température selon une fonction exponentielle, ce qui présente un inconvénient important dans de nombreuses applications. Une explication proposée de ce phénomène est fondée sur l'existence de barrières de potentiel aux joints de grain que les porteurs doivent surmonter pour être transportés à travers la couche de semiconducteur. Enfin sous la forme polycristalline, le silicium absorbe peu la lumière, si bien que l'épaisseur minimale de la couche à déposer pour obtenir un rendement suffisant est de l'ordre de plusieurs dizaines de microns. Or un des facteurs limitant le plus la fabrication de dispositifs de type photovoltaïque est leur prix de revient. Pour réduire le coût, il est donc souhaitable d'utiliser des couches les plus minces possibles, de l'ordre du micron. Pour cela il a été proposé d'utiliser le silicium sous forme amorphe, dont l'absorption optique est nettement supérieure à celle du silicium cristallin.

Cependant, le silicium amorphe présente en général des caractéristiques de conductivité électrique moins bonnes que le silicium cristallin, ce même dans le cas où des procédés tels que ceux décrits dans la demande de brevet français n° 77 17 245 déposée le 6 Juin 1977 et publiée sous le n° 2 394 173 et dans la demande de brevet européen n° 80 401 051.0 déposée le 11 Juillet 1980 et publiée sous le n° 0 024 378, permettant d'améliorer ces caractéristiques sont mis en œuvre.

L'invention se fixe pour but l'obtention de couches semiconductrices de faible épaisseur ayant les qualités d'absorption de la lumière propre au silicium amorphe tout en conservant une très bonne conductivité électrique.

Ce but peut être atteint en réalisant simultanément les deux conditions suivantes : l'introduction dans une gamme précise pendant le processus de dépôt d'une quantité d'au moins un élément différent du silicium choisi parmi les éléments de la colonne IVa de la classification périodique, notamment le germanium, et le choix d'une température de dépôt égale ou légèrement supérieure à la température de cristallisation.

Il est par ailleurs connu par les demandes de brevets WO-A-79/00 724 (ENERGY CONVERSION DEVICES) et EP-A-0 003 237 (I.B.M.) d'introduire lors du dépôt des éléments autres que le silicium, dont des éléments de la colonne IVa, ce pour obtenir des couches de silicium amorphe, la température de dépôt étant dans tous les cas choisie en conséquence inférieure à la température de cristallisation.

L'invention a donc pour objet un procédé de fabrication de couches de silicium de faible épaisseur ayant les qualités d'absorption de la lumière propre au silicium amorphe et doté d'une très bonne conductibilité électrique, caractérisé en ce qu'au moins un autre élément de la colonne IVa de la classification périodique est introduit dans les couches de silicium lors de leur dépôt sur des substrats selon des proportions comprises entre 0,1 % et 5 % d'atomes de cet élément par rapport au nombre d'atomes de silicium, ce dépôt ayant lieu à une température des substrats comprise entre la température de cristallisation T desdites couches et une température allant jusqu'à 50 °C, au-dessus de cette température T.

L'invention s'applique aux dispositifs de conversion photoélectrique comprenant au moins une couche contenant du silicium déposée sur un support et obtenue par ce procédé.

L'invention sera mieux comprise et d'autres caractéristiques et avantages apparaîtront à la lecture de la description ci-après et des figures annexées parmi lesquelles :

la figure 1 représente schématiquement un appareillage permettant le dépôt de couches selon l'invention ;

la figure 2 est un diagramme comparatif mettant en évidence les propriétés de conductivité électrique des couches réalisées selon l'invention par rapport à celles de couches réalisées selon un procédé de l'art connu ;

la figure 3 est un exemple de dispositif de conversion photoélectrique comportant une couche réalisée selon le procédé de l'invention.

Le but de l'invention est d'obtenir des couches de silicium réalisées selon la technique de dépôt en couches minces, couches conservant les bonnes propriétés d'absorption de l'énergie lumineuse du silicium amorphe et dotées d'une conductivité électrique améliorée. Il a été constaté que ce but peut être atteint en introduisant une petite quantité d'au moins un élément différent du silicium pendant le processus de dépôt. Cet élément est destiné à atténuer l'effet des joints de grain. Cet élément ne devra pas modifier de façon appréciable les propriétés du silicium indépendantes de celles dues à la structure en grain. Par exemple il ne devra pas produire un effet de dopage ou une modification importante de la largeur de la bande interdite due à un effet d'alliage. Ces conditions peuvent être simultanément remplies en utilisant un élément de la colonne IVa de la classification périodique (carbone, germanium, étain ou plomb), ce dans des proportions comprises entre 0,1 % et 5 % d'atomes de cet élément par rapport au nombre d'atomes de silicium. Un élément particulièrement intéressant est le germanium.

Un procédé possible de réalisation d'une couche semiconductrice contenant du silicium permettant de mettre en évidence les avantages de l'invention va maintenant être décrit à titre d'exemple non limitatif. Ce procédé comprend au moins une étape de dépôt par décomposition thermique d'un mélange gazeux.

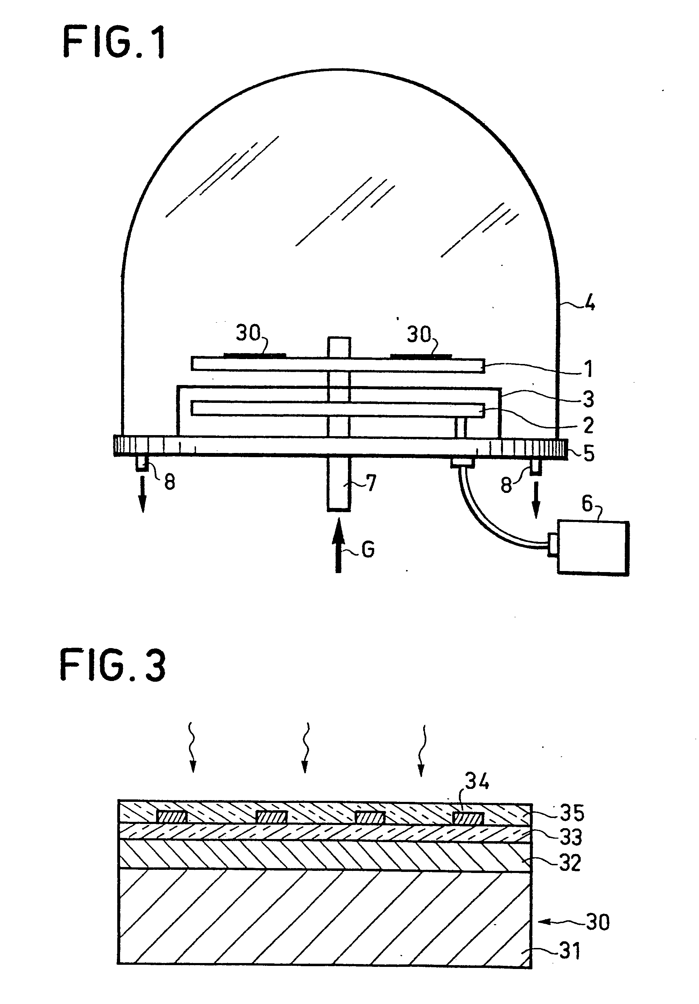

Un appareillage permettant ce dépôt va tout d'abord être décrit en relation avec la figure 1. Sur la figure 1 est représenté schématiquement un réacteur comprenant une chambre de réaction verticale et composée des éléments suivants :

— un suscepteur circulaire 1 en graphite recouvert de carbure de silicium reposant sur un piédestal en quartz (non représenté sur la figure). L'ensemble suscepteur et piédestal est animé d'un mouvement de rotation, réglable typiquement entre 0 et 30 tours par minute ;

— un bobinage comprenant une self spiralée 2, situé dans un plan parallèle au suscepteur 1 et couplé inductivement à celui-ci. La self est reliée à un générateur haute fréquence 6 fonctionnant à 400 KHz et de puissance 25 KW.

— une jupe en quartz 3 isolant la self de la chambre de réaction ;

— une cloche en quartz 4 posée sur un socle également en quartz 5. L'ensemble délimite le volume de la chambre de réaction.

— un injecteur 7 situé au centre du suscepteur permet l'introduction des gaz G à décomposer dans la chambre à réaction, ces gaz étant évacués par le bas du réacteur par les orifices 8.

Les débits gazeux sont mesurés de façon classique à l'aide de tubes débitmètres à bille munis de robinets à soufflet en acier inoxydable. Sur le suscepteur 1 sont représentés, sous la référence 30, des dispositifs en cours de réalisation, c'est-à-dire des dispositifs comprenant au moins un substrat sur lequel vont être déposées une ou plusieurs couches selon le procédé de l'invention. La cloche 4 peut comporter également des fenêtres de visée permettant la mesure de la température de ces dispositifs 30 à l'aide de dispositifs de mesure à infrarouge. Toutes ces dispositions sont bien connues de l'homme de métier.

La méthode retenue pour le dépôt est également connue en soi. Il s'agit de dépôt en phase gazeuse sous pression atmosphérique. La méthode consiste en une décomposition thermique du silane ($SiH_4$) qui est la source de silicium. Le silane est mélangé à de l'argon ou de l'hydrogène, ce dernier gaz donnant de meilleurs résultats, dans une proportion volumique de 90 % pour l'hydrogène ou l'argon et de 10 % pour le silane. Le mélange peut comprendre un troisième gaz fournissant le dopant, par exemple l'arsine pour l'arsenic, le diborane pour le bore ou la phosphine pour le phosphore. La proportion de ce dernier gaz par rapport au silane doit être réglée de façon très précise suivant le degré de dopage désiré. Cette proportion peut varier typiquement de $10^{-6}$ à $10^{-3}$ molécules de gaz dopant pour une molécule de silane. Le substrat sur lequel est déposé la couche contenant du silicium dépend de la structure du dispositif électronique à réaliser. Le traitement préliminaire de ces substrats sort du cadre de l'invention et ne sera pas décrit. Le dépôt croît à une vitesse d'environ 1 $\mu$m par heure.

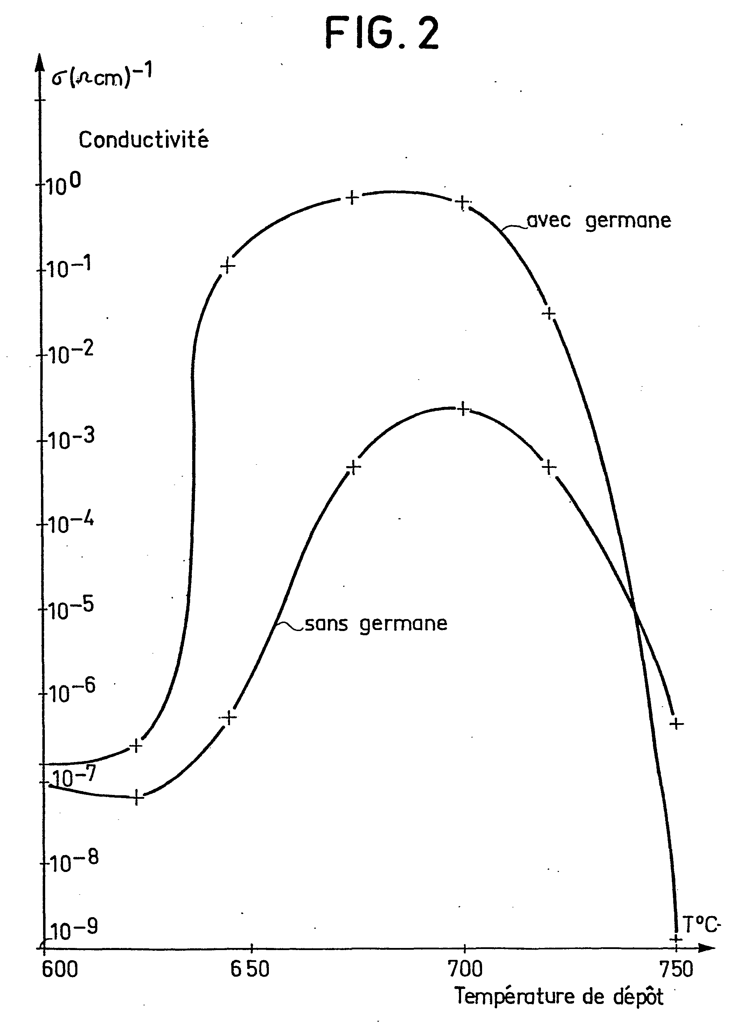

Pour illustrer l'invention les caractéristiques de conductivité électriques d'une couche réalisée selon le procédé de l'invention, c'est-à-dire dans laquelle un élément de la colonne IVa a été introduit dans les proportions qui ont été précédemment indiquées, ont été comparées aux caractéristiques de conductivité électrique d'une couche ne comprenant pas cet élément c'est-à-dire une couche déposée selon un procédé de l'art connu. Pour ce faire plusieurs couches ont été réalisées à des températures de dépôt différentes, les autres paramètres étant identiques. Une première série de couches a été réalisée par décomposition d'un gaz comprenant de l'hydrogène, du silane ($SiH_4$) et de la phosphine ($PH_3$). Une seconde série de couches a été réalisée par décomposition d'un gaz comprenant ces mêmes éléments et dans lequel a été adjoint du germane ($GeH_4$), la proportion moléculaire étant $10^4$ molécules de silane pour une molécule de germane. Cette proportion moléculaire conduit à une proportion d'environ 1 % d'atomes de germanium par rapport au nombre d'atomes de silicium dans la couche déposée. Cette proportion a été mesurée par spectographie AUGER. Cette proportion est comprise dans la gamme précédemment mentionnée (0,1 %-5 %). La conductivité électrique en (Ohms.cm)$^{-1}$ de ces différentes couches a été mesurée en fonction de la température de dépôt. Les résultats de ces mesures sont rassemblés sur le diagramme de la figure 2. L'échelle des conductivités est une échelle logarithmique.

Pour les températures de dépôt de l'ordre de 600 °C le silicium obtenu est amorphe et les conductivités électriques sont faibles. La température de début de cristallisation se situe aux alentours de 630 °C et la conductivité est alors fortement augmentée. La température de cristallisation peut être définie par la technique connue de diffraction des rayons X par une couche de matériau. Il est connu en effet qu'une couche monocristalline produit un réseau de diffraction régulier en raison de la structure de type cubique diamant des cristaux. Avec une couche amorphe, on ne distingue plus que des halos caractéristiques de l'arrangement tétrahédrique des atomes. Lorsqu'on observe la figure de diffraction obtenue pour des dépôts effectués à des températures croissantes, pour des basses températures, la couche étant amorphe, la figure est formée de halos mentionnés ci-dessus. A partir d'une certaine température T, que l'on appellera dans ce qui suit température de cristallisation, on constate une modification progressive des halos, dans le sens d'un rétrécissement. Ces halos tendent à se transformer en raies de diffraction étroites caractéristiques d'un cristal donné. Cette modification est facilement observable et permet de définir la température de cristallisation T avec précision. Dans des conditions de dépôt données, définies notamment par la structure du réacteur dans lequel s'effectue la décomposition et par la composition du mélange gazeux, la température de cristallisation est égale à la température T définie comme ci-dessus. Pour du silicium pur elle est égale à environ 630 °C. On constate que pour des températures allant jusqu'à 50 °C au-dessus de cette température T, le coefficient d'absorption optique varie peu et est donc voisin de celui d'une couche amorphe déposée à basse température. Par ailleurs pour des températures de dépôt comprises dans cette gamme de température, la couche obtenue est très homogène, la répartition des défauts, et notamment des liaisons chimiques non établies, est continue.

Si l'on se reporte de nouveau à la figure 2, on constate que les deux courbes de conductivité électrique passent par un maximum pour une température comprise dans la gamme précitée. D'autre part les couches réalisées selon le procédé de l'invention, c'est-à-dire avec introduction d'un élément de la colonne IVa, dans le cas présent cet élément étant du germanium, présente une conductivité améliorée dans une très forte proportion. A titre d'exemple, pour une température de dépôt de 645 °C, le rapport entre les conductivités des couches obtenues sans germane et de la couche obtenue avec germane est de $1,4 \cdot 10^3$. Pour une température de 700 °C (maximum de la courbe de conductivité des couches obtenues par dépôt sans germane) le rapport est de $2,8 \cdot 10^2$. L'invention permet donc d'améliorer dans des proportions considérables la conductivité électrique des couches contenant du silicium.

Une autre propriété remarquable peut être observée par l'expérience, propriété qui indique que le procédé de l'invention est particulièrement intéressant pour la réalisation de photopiles. La couche déposée à 645 °C, et dont la conductivité est proche de l'optimum, a une absorption optique élevée proche de celle observée pour l'état amorphe. Pour les températures plus élevées (> 680 °C) la couche redevient fortement transparente comme c'est le cas pour le silicium polycristallin usuel. A titre d'exemple, pour une longueur d'onde de 0,6 μm, le coefficient d'absorption optique est de $4 \cdot 10^4$ cm$^{-1}$ environ. Ce coefficient peut être comparé à celui de l'état amorphe (dépôt à 600 °C) qui est environ $5 \cdot 10^4$ cm$^{-1}$ par rapport à celui d'une couche polycristalline typique qui est $5 \cdot 10^3$ cm$^{-1}$. Ce coefficient permet de réaliser des dispositifs de conversion photoélectrique par exemple des photopiles, dont la couche contenant du silicium a une épaisseur inférieure ou égale à $10^{-6}$ cm, ce qui pour une couche polycristalline usuelle conduirait à des rendements énergétiques très faibles étant donné que peu de photons du spectre solaire seraient absorbés dans un tel dispositif. L'absorption optique élevée de la phase amorphe permet la réalisation de telles photopiles en couches minces, mais les rendements de ces photopiles sont diminués en raison des médiocres propriétés de transport électrique de la structure amorphe. Les couches déposées à une température de l'ordre de 650 °C par le procédé de l'invention permettent donc d'obtenir des propriétés électriques nettement supérieures à celles des couches amorphes, tout en conservant des absorptions optiques similaires.

Le procédé de dépôt des couches qui vient d'être rappelé n'est pas limitatif des procédés utilisables par l'invention. On peut notamment mettre en œuvre les procédés de dépôt en phase vapeur (appelés couramment « C.V.D » selon l'expression anglo-saxone « chemical vapor deposition ») sous pression ou sous plasma, ainsi que le procédé de copulvérisation. D'autre part les autres hydrures de silicium sont également utilisables à la place du silane.

Il a été indiqué dans le préambule de la présente description que la conductivité électrique du silicium à l'état amorphe pouvait être améliorée par la mise en œuvre de certains procédés et notamment du procédé décrit dans la demande de brevet européen n° 80 401 051.0 précitée. Ce procédé de réalisation d'une couche contenant du silicium comprend une première étape de dépôt de la couche par décomposition chimique d'un mélange gazeux contenant du silane à une température voisine de la température de cristallisation et une deuxième étape pendant laquelle cette couche déposée est traitée dans un plasma d'hydrogène à une température inférieure à la température de cristallisation. La méthode de dépôt mise en œuvre dans la présente invention peut être identique à la première étape du procédé décrit dans la demande de brevet précitée à l'exception près qu'un élément de la colonne IVa de la table périodique est adjoint dans des proportions définies au silicium de la couche déposée. Le procédé de l'invention diffère également par la température de dépôt sélectionnée, le silicium obtenu par la demande précitée devant être un silicium à l'état amorphe. La bonne conductivité de la couche de silicium obtenue par le procédé de l'invention peut être encore améliorée par le traitement de la couche déposée par une méthode analogue à celle de la seconde étape de la demande de brevet précitée.

Pour ce faire la couche déposée est traitée dans un plasma d'hydrogène ou d'un de ses isotopes ou d'un mélange de ces corps. Le traitement, effectué à une température de l'ordre de 350 °C à 450 °C, inférieure à la température de cristallisation T, a pour but d'introduire des atomes d'hydrogène dans des liaisons chimiques non établies afin de passiver la couche déposée. A titre d'exemple, une couche d'environ 1 μm d'épaisseur a été réalisée dans le procédé de l'invention par décomposition chimique d'un mélange gazeux constitué de silane, de phosphine et de germane dilué dans de l'hydrogène. La température de dépôt a été de 645 °C et le temps nécessaire pour effectuer le dépôt a été d'environ une heure. La conductivité électrique de la couche mesurée est de 2,5 (Ohms. cm)$^{-1}$. Si on se reporte de nouveau à la figure 2, une couche réalisée avec adjonction de germane, mais sans traitement ultérieur sous plasma, a une conductivité électrique d'environ 1,2 10$^{-1}$ (Ohms. cm)$^{-1}$. Le traitement sous plasma permet donc une amélioration de la conductivité supplémentaire dans un rapport de l'ordre de 20 dans ce cas précis.

Dans tous les cas, les couches contenant du silicium obtenues par le procédé de l'invention, même sans la mise en œuvre de l'étape supplémentaire qui vient d'être décrite, permettent d'obtenir un bon rendement énergétique lorsqu'elles sont appliquées à la conversion photoélectrique.

A titre d'exemple non limitatif, une pile solaire du type comportant une jonction métal-silicium est représentée sur la figure 3. La pile solaire 30 comprend un substrat métallique 31 assurant la rigidité mécanique de l'ensemble. On peut citer comme matériaux types d'aluminium, le chrome, l'acier inoxydable ou le fer. Sur la surface supérieure du substrat métallique 31 est déposée selon le procédé de l'invention une couche contenant du silicium 32. Comme il a été rappelé, cette couche peut avoir une épaisseur de l'ordre de 0.5 à 1 μm. Outre le silicium, des atomes de germanium, par exemple, ont été introduits dans la proportion indiquée, c'est-à-dire dans la gamme 0.1 % à 5 % d'atomes de germanium. D'autre part, des impuretés de type n ont été introduites dans une proportion également déterminée, ce en incorporant de la phosphine au gaz introduit dans le réacteur de la figure 1. La couche 32 contenant du silicium est ensuite recouverte d'une mince couche métallique 33, par exemple du platine, cette couche restant du fait de sa minceur transparente aux rayons solaires auxquels doit être exposée la couche 32. L'interface entre les couches 32 et 33 forme une jonction de type Schottky. Les photons traversent la couche métallique 33 pratiquement sans être absorbés. Ils sont par contre absorbés par la couche contenant du silicium 32 qui, comme il a été rappelé, peut avoir un coefficient d'absorption de l'ordre de 4 10$^4$ cm$^{-1}$ pour une longueur d'onde égale à 0,6 μm, si bien que, pour une épaisseur de la couche 32 de l'ordre de 1 μm, la portion de rayonnement absorbée est peu différente de l'unité. Les photons absorbés génèrent des paires électrons-trous qui sont dissociées dans la couche 32, libérant ainsi des électrons pouvant circuler vers la couche 33. Le dispositif de la figure 3 est complété par l'adjonction d'une grille métallique 34 formant électrode, réalisée en métal de bonne conductivité électrique. La grille peut être constituée, par exemple, de deux séries de fils parallèles, les fils de la première série étant disposés suivant une direction orthogonale à la direction des fils de la seconde série. La surface occupée par cette électrode peut être réduite au minimum et être par exemple de l'ordre de 5 à 10 % de la surface utile du dispositif. Cette grille formant électrode a pour but de recueillir de façon uniforme le courant circulant dans la couche 33, ce sous faible résistance électrique. Enfin une couche superficielle antiréfléchissante 35 est disposée sur la couche 33 englobant la grille formant électrode 34. Comme il est bien connu l'épaisseur e de cette couche est reliée à la longueur d'onde par la relation suivante :

$$e = \lambda/4 \ n$$

relation dans laquelle λ est la longueur d'onde de la radiation lumineuse à convertir et n est l'indice de réfraction optique de la couche 35. Dans le cas d'un spectre étendu une valeur de longueur d'onde moyenne sera sélectionnée. Lorsque le dispositif est éclairé on peut obtenir un courant électrique proportionnel à l'éclairement en reliant la grille formant électrode 34, d'une part, et le substrat 31 conducteur, d'autre part, à un circuit de charge extérieure non représenté.

**Revendications**

1. Procédé de fabrication de couches de silicium de faible épaisseur ayant les qualités d'absorption de la lumière propre au silicium amorphe et doté d'une très bonne conductibilité électrique, caractérisé en ce qu'au moins un autre élément de la colonne IVa de la classification périodique est introduit dans les couches de silicium lors de leur dépôt sur des substrats selon des proportions comprises entre 0,1 % et 5 % d'atomes de cet élément par rapport au nombre d'atomes de silicium, ce dépôt ayant lieu à une température des substrats comprise entre la température de cristallisation T desdites couches et une température allant jusqu'à 50 °C au-dessus de cette température T.

2. Procédé selon la revendication 1 caractérisé en ce que l'élément de la colonne IVa de la classification est le germanium.

3. Procédé selon la revendication 2, caractérisé en ce que le dépôt est effectué en phase gazeuse par décomposition thermique d'un mélange gazeux comprenant un hydrure de silicium, ainsi qu'un hydrure d'un élément de la colonne IVa, de la classification périodique.

4. Procédé selon la revendication 3, caractérisé en ce que l'hydrure de silicium est du silane.

5. Procédé selon la revendication 3, caractérisé en ce que l'hydrure d'un élément de la colonne IVa est du germane.

6. Procédé selon la revendication 3, caractérisé en ce qu'en outre le mélange gazeux comprend un composé gazeux d'un élément dopant de type n ou p.

7. Procédé selon l'une quelconque des revendications 1 à 6, caractérisé en ce qu'il comprend une étape postérieure au dépôt pendant laquelle la couche de silicium contenant au moins un autre élément de la colonne IVa de la classification périodique est soumise à un traitement thermique en présence d'un plasma contenant de l'hydrogène ou l'un de ses isotopes, la température de traitement étant choisie inférieure à la température de cristallisation T, dans une gamme comprise entre 350 °C et 450 °C.

8. Dispositif de conversion photoélectrique (30) comprenant au moins une couche (32) contenant du silicium, réalisée par le procédé de l'une quelconque des revendications 1 à 7.

## Claims

1. A method for producing layers of silicon of small thickness having the light absorption qualities of amorphous silicon, and with a very good electrical conductivity, characterized in that at least one other element of group IVa of the Periodic System is introduced in the layers of silicon during their deposition upon substrates in proportions of between 0,1 % and 5 % of atoms of this element in relation to the number of silicon atoms, this deposition taking place at a temperature of the substrate between the temperature of cristallisation T of said layers and a temperature of up to 50 °C above this temperature T.

2. A method according to claim 1, characterized in that the element of the group IVa of the Periodic System is germanium.

3. A method according to claim 2, characterized in that the deposition is effected in gaseous phase by thermal decomposition of a gaseous mixture comprising a hydride of silicon and a hydride of an element of the group IVa of the Periodic System.

4. A method according to claim 3, characterized in that the hydride of silicon is silane.

5. A method according to claim 3, characterized in that the hydride of an element of the group IVa is germane.

6. A method according to claim 3, characterized in that the gaseous mixture comprises in addition a gaseous compound of a doping element of type n or p.

7. A method according to any one of claims 1 to 6, characterized in that it comprises a step after the deposition during which step the layer of silicon containing at least one other element of the group IVa of the Periodic System is subjected to a thermal treatment in the presence of a plasma containing hydrogen or one of its isotopes, the temperature of the treatment being chosen lower than the temperature of cristallisation T in a range between 350 °C and 450 °C.

8. Apparatus for photoelectric conversion (30) comprising at least one silicon containing layer (32) which has been prepared by the method of any one of claims 1 to 7.

## Ansprüche

1. Verfahren zur Herstellung von Siliciumschichten geringer Dicke mit den für amorphes Silicium eigentümlichen Lichtabsorptionseigenschaften und mit einer sehr guten elektrischen Leitfähigkeit, dadurch gekennzeichnet, daß in die Siliciumschichten bei ihrer Abscheidung auf Substraten wenigstens ein anderes Element der Gruppe IVa des Periodischen Systems in Anteilen zwischen 0,1 % und 5 % der Atome dieses Elements bezüglich der Zahl der Siliciumatome eingeführt wird, wobei diese Abscheidung bei einer Temperatur des Substrats stattfindet, die zwischen der Kristallisationstemperatur T der Schichten und einer bis 50 °C oberhalb dieser Temperatur T liegenden Temperatur liegt.

2. Verfahren nach Anspruch 1, dadurch gekennzeichnet, daß das Element der Gruppe IVa des Periodischen Systems Germanium ist.

3. Verfahren nach Anspruch 2, dadurch gekennzeichnet, daß die Abscheidung in Gasphase durch thermische Zersetzung eines Gasgemisches erfolgt, das ein Siliciumhydrid sowie ein Hydrid eines Elements der Gruppe IVa des Periodischen Systems enthält.

4. Verfahren nach Anspruch 3, dadurch gekennzeichnet, daß das Siliciumhydrid Silan ist.

5. Verfahren nach Anspruch 3, dadurch gekennzeichnet, daß das Hydrid eines Elements der Gruppe IVa German ist.

6. Verfahren nach Anspruch 3, dadurch gekennzeichnet, daß das Gasgemisch außerdem eine gasförmige Verbindung eines Dotierungselements vom Typ n oder p enthält.

7. Verfahren nach einem der Ansprüche 1 bis 6, dadurch gekennzeichnet, daß es eine auf die Abscheidung folgende Stufe aufweist, während der die Siliciumschicht, die mindestens ein anderes Element der Gruppe IVa des Periodischen Systems enthält, einer Wärmebehandlung in Gegenwart eines Plasmas unterworfen wird, das Wasserstoff oder eines seiner Isotopen enthält, wobei die Behandlungstemperatur so gewählt wird, daß sie unter der Kristallisationstemperatur T in einem Bereich zwischen 350 °C und 450 °C liegt.

8. Vorrichtung zur fotoelektrischen Umwandlung (30), die mindestens eine Silicium enthaltende Schicht (32) aufweist, die nach dem Verfahren eines der Ansprüche 1 bis 7 hergestellt ist.

# FIG.1

# FIG.3

0 042 773

FIG. 2

Conductivité

avec germane

sans germane

Température de dépôt